# EUROPEAN PATENT SPECIFICATION

(11) **EP 3 694 066 B1**
(45) Date of publication and mention of the grant of the patent: **16.09.2026**
(21) Application number: 17927944.3
(22) Date of filing: 05.10.2017
(51) Int. Cl.: G01R 31/52, H02H 1/00, H02H 3/52

(54) **ARC PROTECTION DEVICE AND OPERATING METHOD THEREOF**
LICHTBOGENSCHUTZVORRICHTUNG UND BETRIEBSVERFAHREN DAFÜR
DISPOSITIF DE PROTECTION CONTRE LA FORMATION D'ÉTINCELLES ET PROCÉDÉ DE FONCTIONNEMENT

(43) Date of publication of application: 12.08.2020
(73) Proprietor: Nemtsov, Anna, 03182 Torrevieja (Alicante) (ES)
(72) Inventor: Mkrtumov, Aleksandr Sergeevich, Moscow, 125057 (RU); Nemtsov, Alexey Nikolaevich, Moscow 111538 (RU); Nemtsov, Fedor Nikolaevich, Moscow 109559 (RU)
(74) Representative: Mutlu, Aydin
(86) International application number: PCT/RU2017/000741
(87) International publication number: WO 2019/070147

(56) References cited:
- RU-C2- 2 528 137
- US-A- 5 835 321
- US-A1- 2003 074 148
- US-A1- 2008 204 949
- US-A1- 2008 204 950
- US-A1- 2014 218 044
- US-A1- 2014 347 065

## Description

This invention relates to the field of fire-safety and power engineering, namely to methods and devices for detecting arcing in electrical networks and electrical installations, thus preventing fires, in compliance with the requirements to arc fault detection devices (arc protection devices, hereinafter, also AFDD) according to, in particular, IEC 62606:2013 Standard: General requirements for arc fault detection devices as well as to GOST IEC 62606-2016 Standard: Arc Fault Detection Devices for Household and Similar Use. General Requirements*,* or other technical requirements applicable to devices for protection from arcing in electrical networks and electrical installations.

An arc protection device (AFDD) is a device comprising an arc fault detection unit (also, arcing detection unit, spark detection unit) and a circuit-interrupting unit (also, disabling member, circuit breaker). An AFDD is intended for operation in difficult electromagnetic circumstances and should comply with mostly contradictory requirements as to sensitivity, noise immunity and absence of false activations from normal operation of equipment. Therefore, so that an AFDD can operate successfully, it is desirable to collect, if possible, versatile information on processes occurring in a protected circuit.

Thus, US Patent Application No. 20160187409 describes an AFDD detecting and analyzing current pulses in a low-frequency band, voltage pulses in a low-frequency band, and intensity of current high-frequency components. The process of analysis is initiated upon detecting a rise of current in the low-frequency band above a pre-determined threshold level. In the final stage of analysis, a high-frequency current oscillations generated by wide-band fluctuations peculiar to an arc are checked in several frequency sub-bands. Being a characteristic feature of an arc fault, these fluctuations are, at the same time, rather weak, which creates certain problems for developing an AFDD with great values of nominal current. Great values of nominal current correspond, on an average, to a wider service area covering a greater number of connected electric appliances and to a protected line of greater length and branching, which may lead to a significant reduction in transmission of current high-frequency components from a spot where an arcing occurs to an AFDD. As a result, signals isolated by band-pass filters from these fluctuations may be reduced to a level of background noise existing in the protected line in that time. Thus, the above fluctuations are used for detecting arcing in the Siemens 5SM6 AFDD (see, e.g., https://support.industry.siemens.com/cs/document/109744645/brochure). At a high level of background noise, this AFDD simply changes to the mode of limited functioning, thereof a user is informed by the corresponding indication.

Thus, in great service areas, detection of wide-band current fluctuations used in the above-mentioned and other known AFDDs may be difficult due to a small amplitude of analyzed signals.

Current pulses selected by high-frequency filters when an arc fault occurs have a substantially greater amplitude under otherwise equal conditions. Detection of an arcing by using these pulses is disclosed, for example, in US Pat. No. 5280404 or RU Pat. No. 2528137.

The AFDDs and the method for detecting arcing according to RU Pat. No. 2528137 may be recognized as the closest analogs of the subject matter of the present invention. US2014347065A1 describes a method for detecting a sustained arc in an electrical system. According to this document, current and voltage data for a load signal are collected over a period and spectral information is extracted.

Solutions based on this principle, including the closest analog, will react and trigger even at low-power high-frequency events that are normal, e.g. when firing luminescent tube units with an electromagnetic start-controlling apparatus.

The object of this invention is to eliminate the above-described limitations and disadvantages of the known arc protection devices and methods of operating thereof.

The technical effect of this invention is an increase in the accuracy of arcing event detection, a reduction in the number of false activations of an arc protection device, and an increase in the working range, the number of connected electrical appliances, the length of the protected circuit and the number of branches it contains.

The above object is solved and the claimed technical effect is achieved according to the proposed in claim 1 method of operating an arc protection device, wherein voltage signals and current signals in a protected circuit are measured in each voltage half-cycle; on the basis of measured voltage and current deviations the presence of an isolated arc is determined in each voltage half-cycle; information on isolated arcs over a set time period is gathered and stored as the arcing parameter. When the arcing parameter reaches a pre-set value, arc fault is detected, and a signal for disconnecting the protected circuit is generated. At the same time, the process of measuring voltage and current includes measuring current in a high-frequency band, measuring current in a mid-frequency band, measuring voltage in a low-frequency band, and measuring voltage in a mid-frequency band.

The introduction of current measuring in the mid-frequency band and voltage measuring in the mid-frequency band into the conventional methods of operating an AFDD does not simply increase the number of criteria of determining an arcing in a protected circuit, but also enables to monitor arcing occurrences in the conditions when arcing signals are well represented on noise background and signals from normally operating equipment not only in a protected circuit, but also in adjacent circuits of an electrical grid. This enables to reduce a number of false activations of an arc protection device. Consequently, in comparison with the conventional operating methods of an AFDD, the claimed method ensures an enlargement of a service area covering a greater number of connected electrical appliances and increases length of a protected circuit and a number of branches it contains .

In a preferred embodiment of the invention, current is measured in the mid-frequency band, voltage is measured in the mid-frequency band, and voltage is measured in the low-frequency band only on the condition that a value of current measured in the high-frequency band is greater than a pre-determined level, also current in the high-frequency band being measured in the sub-band from 1 to 10 MHz at a segment where a rise in the electrical network voltage module is detected. This enables to reduce an amount of "excess" information processed by the arc protection device and, consequently, to reduce the requirements to volume and speed of information processing in the device.

In the process of determining an isolated arc , an arcing current may be determined by measuring voltage in the low-frequency band and measuring current in the mid-frequency band. If the arcing current does not correspond to preset values, measuring in respect of the existing event is stopped, which also enables to reduce a volume of excess information processed by the arc protection device, and, furthermore, to exclude false activations of the arc protection device.

Simultaneously with determining arcing current, it is to determine polarities of voltage signals in the mid-frequency band by voltage measurements in the mid-frequency band, and to confirm the presence of an isolated arc exactly in the protected circuit by polarities of voltage signals in the mid-frequency band and polarities of current signals in the mid-frequency band. This enables to detect arcing signal at noise background in the protected circuit and adjacent circuits with high accuracy.

Also, the above task is solved, and the claimed technical effect is achieved by the proposed arc protection device of claim 4 comprising a power unit, at least one current sensor, at least one voltage reading unit, a high-frequency current signal detecting unit, a mid-frequency current signal detecting unit, a microcontroller, and a disconnection member. The microcontroller is configured to interact with the high-frequency current signal detecting unit and the mid-frequency current signal detecting unit for measuring current in the high-frequency band and current in the mid-frequency band, respectively, interact with the voltage reading unit for measuring voltage in the low-frequency band and the mid-frequency band, determine an isolated arc fault event, gather information about arcs over a set time period and store it in the form of an arcing parameter, and generate a disconnection signal when the arcing parameter reaches a preset value.

The claimed arc protection device is an embodiment of such device implementing the claimed method of operating the arc protection device; and all the advantages of the claimed method are realized in the claimed device.

Some possible embodiments of the invention that, however, do not limit this invention, are disclosed in detail below with reference to the accompanying drawings, wherein:
Figure 1 shows an embodiment of the arc protection device and its connection to a circuit to be protected.
Figure 2 shows a general schematic diagram of operation of the arc protection device according to the claimed method.
Figure 3 shows a schematic diagram of high-frequency initiation (HF-initiation) of measurements.
Figure 4 shows a typical histogram of voltage value distribution at an arc fault.
Figure 5 shows typical noise produced by a laptop power unit and a light-emitting diode lamp.
Figure 6 shows a modulation curve for a high-frequency voltage signal identification threshold.
Figure 7 shows a schematic diagram of detecting an isolated arc upon HF-initiation.
Figure 8 shows oscillograms of a current rise during an arc fault.
Figure 9 shows an example of a signal from the power monitoring circuit.
Figure 10 shows an example of a signal from a mid-frequency voltage sensor.
Figure 11 shows a conditional schematic diagram of detecting disturbances by the sensors of the arc protection device.
Figure 12 shows a polarity table for mid-frequency current signals and mid-frequency voltage sensor signals when switching loads.

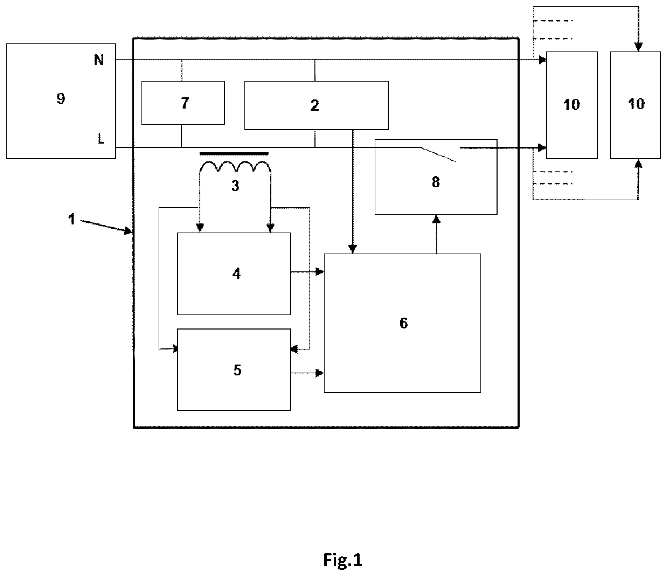

Figure 1 shows an embodiment of the arc protection device (or AFDD) (1) according to this invention and its connection to a circuit to be protected.

The AFDD (1) comprises a voltage reading unit (2), a current sensor (3), a high-frequency current signal detecting unit (4), a mid-frequency current signal detecting unit (5), a microcontroller (6), a power unit (7), and a disconnection member (8).

These components of the AFDD (1), except for the disconnection member (8), form the arc fault detection unit.

The AFDD (1) may be connected to a line between a power entrance board (9) or another power supply unit, or an electrical supply network, and electrical installations (10) of a circuit to be protected.

The voltage reading unit (2) comprises two voltage sensors: a low-frequency voltage sensor and a mid-frequency voltage sensor. The low-frequency voltage sensor is used together with the microcontroller (6) for detecting and subsequently analyzing an existing value of the electrical network voltage with a rather big sampling rate, in particular 10-40 kHz, preferably 20-30 kHz. The mid-frequency voltage sensor is used together with the microcontroller (6) for detecting and subsequently analyzing voltage pulses in the mid-frequency band app. from 1 to 50 kHz, preferably from 5 to 50 kHz.

Generally, the low-frequency voltage sensor and the mid-frequency voltage sensor may be separate devices. A number of low-frequency voltage sensors and a number of mid-frequency voltage sensors as well as a number of voltage reading units (2) may vary, depending on a task to be solved and may be defined, for example, by a number of phases and/or circuits to be protected.

The voltage reading unit (2) may have any conventional configuration and, in the simplest case, it is a voltage divider for taking measurements in the low-frequency band and a differentiating circuit for taking measurements in the mid-frequency band.

The current sensor (3) is intended for taking current signals from which subsequently, by means of the high-frequency current signal detecting unit (4), the mid-frequency current signal detecting unit (5) and the microcontroller (6), mid-frequency current signals (current measured in a band app. from 0.1 to 30 kHz, preferably from 0.3 to 15 kHz) and high-frequency current signals (current measured in a band app. from 1 to 10 MHz) are isolated and analyzed.

Depending on a task to be solved, several current sensors (3) may be used. For example, two current sensors (3) may be used, one of them is operated jointly or is combined with the high-frequency current signal detecting unit (4), and the second one is operated jointly or is combined with the mid-frequency current signal detecting unit (5).

The current sensor (3) may have any conventional configuration and, in the simplest case, is a current transformer.

The microcontroller (6) is intended for processing signals received from the voltage reading unit (2), the current sensor (3), the high-frequency current signal detecting unit (4) and the mid-frequency current signal detecting unit (5), and for determining an event of an arcing occurred in the protected line and generating a control signal for the disconnection member (8).

The power unit (7) supplies power to the microcontroller (6) and, if necessary, to the disconnection member (8).

The disconnection member (8), upon receiving a control signal from the microcontroller (6), breaks the circuit supplying power to electrical installations (10), i.e. disconnects the protected circuit from the electrical supply network. Depending on the device design, the circuit may be broken not only in the path L of phase current (shown as an example in Figure 1), but also in the path N of neutral current.

The arc protection device (1) operates as follows.

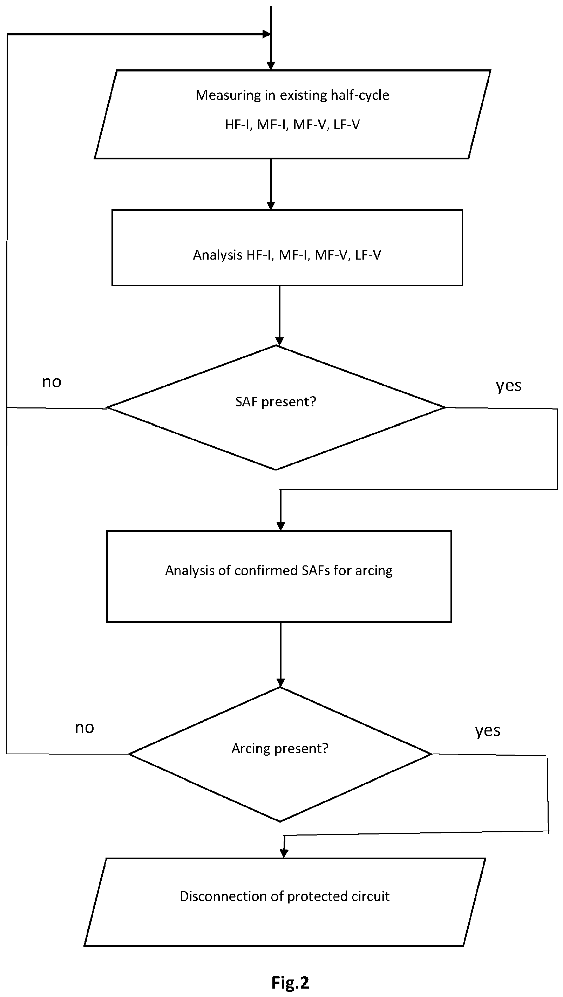

The microcontroller (6) analyzes signals received from the voltage reading unit (2) and signals received from the current sensor (3) through the high-frequency current signal detecting unit (4) and the mid-frequency current signal detecting unit (5). A decision on presence of an arcing in the protected circuit with the parameters requiring, according to the criteria of GOST IEC 62606-2016 or another document, disconnection of the electrical installations (10) from the power supply line is taken in two steps schematically shown in the schematic diagram in Figure 2.

In the first step, the microcontroller (6) determines a presence of and assesses parameters of an isolated arc (IA) in the present half-cycle of the electrical network voltage by analyzing and comparing the following signals:
1) a signal received from the low-frequency voltage sensor (this signal is indicated as LF-V in Figure 2) to determine current electrical network voltage;
2) a signal received from the current sensor (2) in a band app. from 1 to 10 MHz, i.e. in the high-frequency band (this signal is indicated as HF-I in Figure 2);
3) a signal received from the current sensor (2) in a band app. from 0.1 to 20 kHz, preferably from 0.3 to 15 kHz, i.e. in the mid-frequency band (this signal is indicated as MF-I in Figure 2);
4) a signal received from the mid-frequency voltage sensor (this signal is indicated as MF-V in Figure 2) at a frequency app. from 1 to 50 kHz, preferably from 5 to 50 kHz.

Upon receiving and analyzing these signals, the microcontroller (6) determines whether an isolated arc (IA) is present, and, if the answer is positive, then, in the second step of the AFDD operation, a sequence of confirmed IAs is analyzed for the purpose of determining arcing. If arcing is confirmed, the microcontroller (6) generates a signal for the disconnection member (8) to disconnect the protected circuit from the electrical network.

Below, each of the steps is described in more detail, staring from the first step.

A zero-crossing phase of electrical network voltage is determined according to a signal from the low-frequency voltage sensor, i.e. signal LF-V.

Then, time intervals, when subsequent measurements are to be taken, are determined. These time intervals correspond to the region of a rise in the electrical network voltage, i.e. lie in the angular sectors of 0-90° and 180-270° of a voltage sinusoid after zero-crossing of electrical network voltage. Repeated arc faults are extremely unlikely in the regions of a droop in the electrical network voltage module, and, therefore, it is unreasonable to measure accidental or regular noise of any kind in this regions.

Then, a current signal from the current sensor (2) is subject to frequency filtering, by means of the high-frequency current signal detecting unit (4), to remove frequency components in a band app. to 1 MHz, thus forming a HF-I signal, and then to amplitude discrimination by means of, for example, a comparator (not shown in the drawings) that may form a part of the microcontroller (6) or is made as a separate unit.

The purpose of this frequency filtering is primary isolation of arcing signals having a great intensity of high-frequency components from noise signals generated by most electrical appliances. If a current signal obtained after said frequency filtering, i.e. a HF-I signal, exceeds a preset value Ipv, it initiates a procedure of taking subsequent measurements (in particular, MF-I, MF-V, LF-V are measured) which is called "high-frequency initiation or HF-initiation" throughout this application. Moreover, as already said, HF-initiation is allowed only in the region of a rise in the electrical network voltage module.

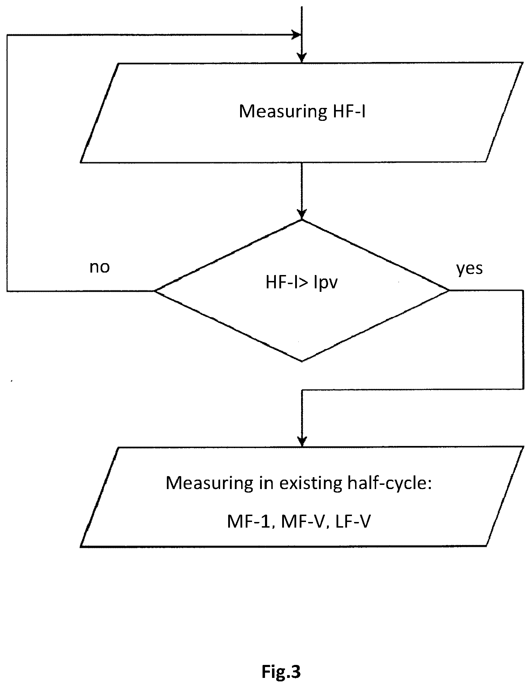

HF-initiation is schematically illustrated in Figure 3.

An amplitude discrimination threshold for high-frequency signals, which is determined by the pre-set value Ipv, is set on the basis of compromise between detection of arcing signals and stability of the AFDD (1) to noise signals produced by electrical installations (10) operating normally. However, amplitudes of arcing signals and noise signals depend on an existing voltage value and, thus, on a phase of an existing voltage value relative to the zero-crossing electrical network voltage. An amplitude of arcing current signals generated by an arcing in the high-frequency and mid-frequency bands is, under otherwise equal conditions, directly proportional to voltage at which an arc fault occurs in a given half-cycle of the network.

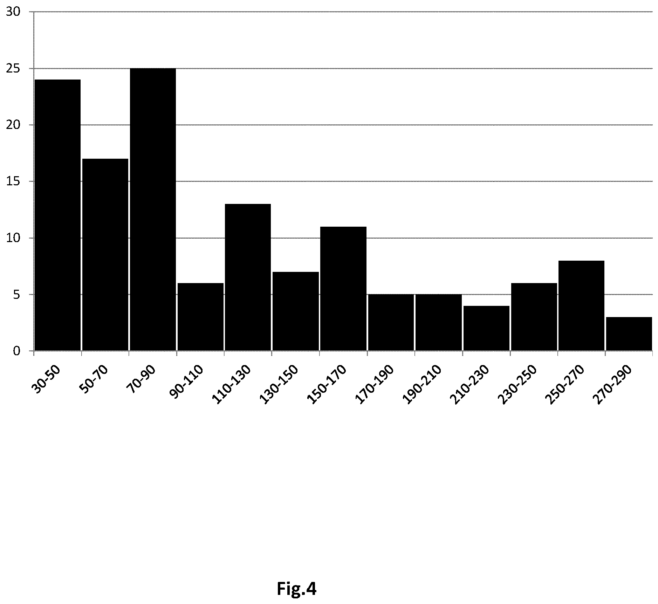

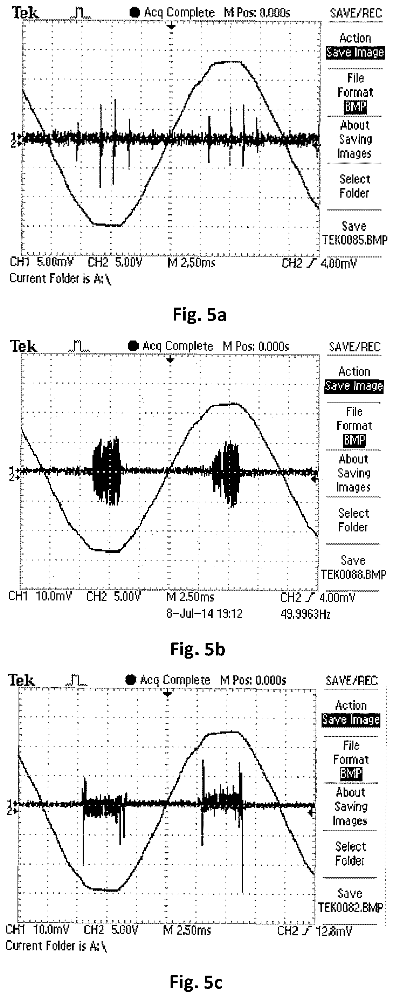

As an example, Figure 4 shows a typical histogram of distribution of arc fault voltage values with an arc current existing value equaling to app. 7A, when a test arc generator made according to Item 9.9.2.7 of IEC Standard 62606:2013 is used. Here, voltage ranges in Volts are indicated on the X-axis, and count numbers are indicated on the Y-axis. It can be seen in Figure 2 that app. a half of arc faults occurs at voltages less than 100V, and the behavior of this distribution depends on hardly predictable factors. Low-voltage arc faults may form a highly dominant part, while having, at the same time, a small amplitude of signals, which makes their detection difficult. At the same time, a level of most noise decreases sharply in the range of voltage values below 100V. As an example, Figure 5 shows phasing of noise at the output of the current sensor (3), as generated by a number of typical sources, relative to the network voltage, in particular, by a free-running power unit (Figure 5a) and by a power unit operating under a load (Figure 5b), as well as by a LED lamp (Figure 5c).

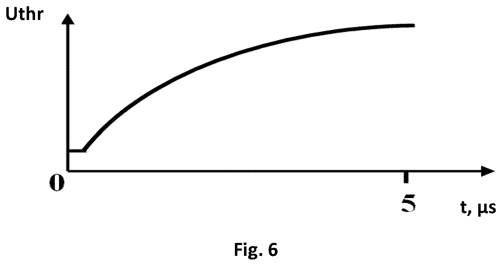

For this reason, in order to optimize arcing signal/noise signal ratio in each half-cycle of the network, it would be reasonable to modulate a discrimination level of a high-frequency current signal (i.e. a HF-initiation threshold) to ensure its proportionality to the network voltage in the range of network voltage values from 30V and above. At lower network voltage values, this level is kept constant to avoid excessive increase of the AFDD (1) sensitivity to noise. The modulation behavior in the positive half-cycle of the network is illustrated in Figure 6 showing a curve of modulation for threshold Uthr of detecting a high-frequency current signal (HF-I). Such modulation may be carried out as modulation synchronous to the network voltage of a reference voltage potential of a comparator discriminating a high-frequency signal at the output of the high-frequency current signal detecting unit (4), the signal being proportional to a current pulse of the current sensor (3).

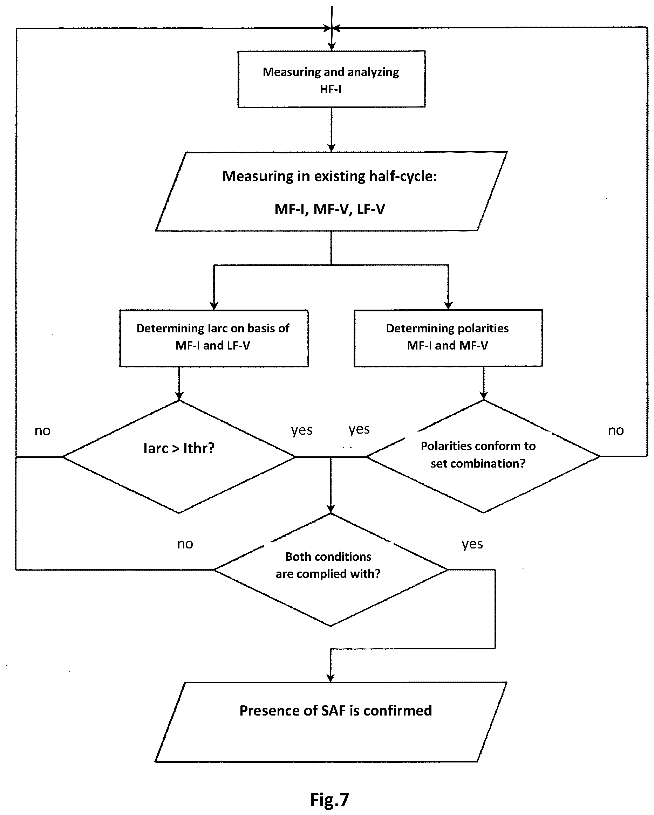

So, HF-initiation serves to initiate taking measurements of MF-I, MF-V, LF-V signals to determine and confirm occurrence of an IA, which is schematically shown in Figure 7.

The purpose of processing of signals from the current sensor (3) in the mid-frequency band (signal MF-I in Figure 7) and signals from the low-frequency voltage sensor (signal LF-V in Figure 7) after HF-initiation is to assess an arc current value based on conductivity of an arcing region of the protected circuit. An amplitude of high-frequency current signals HF-I does not enable to determine arc current reliably, since it greatly depends on *a priori* unknown configuration of the circuit. At the same time, for example, IEC Standard 62606:2013 clearly defines the low level of AFDD sensitivity to arcing current, namely, 2.5A for the network voltage of 230V, since studies show a little possibility of firing at lower values of arcing current. However, reaction to low-current disturbances generated by a number of electrical installations (10) would lead to false activations of the AFDD (1), and, therefore, conductivity discrimination of a circuit region closed at a given time to the network is introduced into the arc fault detection algorithm.

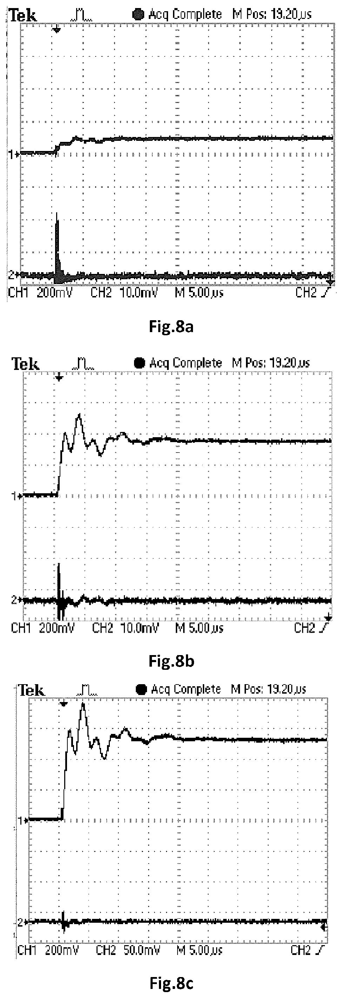

This task can be solved as follows. Parallel to the processing of information received from the current sensor (3) in the high-frequency band, the AFDD (1) performs processing of current signals at significantly lower frequencies by means of a circuit implemented with the use of the mid-frequency current signal detecting unit (5). Hereinafter, this circuit is referred to as the power monitoring circuit (PMC), and the PMC output signal is referred to as a PMC signal. The use of the PMC in the AFDD (1) is conditioned by the fact that, upon expiration of the period of transient processes determined by the circuit reactive parameters, a rise of a mid-frequency current signal MF-I relative to its value before an event occurred is level-stabilized and equals to a quotient obtained by dividing an existing network voltage by an active resistance of the arcing region. Figure 8 shows current oscillograms examples at an arc fault at the same existing network voltage to a load with different resistances in a circuit with reactive components of impedance of 540 Ohm (Figure 8a), 147 Ohm (Figure 8b) and 104 Ohm (Figure 8c), where the upper curve shows a rise of a mid-frequency current signal MF-I, and the lower curve shows a signal of HF-initiation. At the same time, direct proportionality of a rise of a mid-frequency current signal (at its stabilized region) with conductivity of an arcing circuit region clearly appears.

The result is the possibility of determining conductivity of an arcing region by dividing a rise value of a mid-frequency current signal MF-I by an existing network voltage value LF-V which is continuously read with a rather high rate, in particular, 10-40 kHz, more preferably 20-30 kHz, by the microcontroller (6) from the voltage reading unit (2). For selecting a frequency band used for analyzing PMC signals, a time interval and an algorithm of this analysis, the following requirements should be taken into account:
1) PMC signals are formed in the mid-frequency current signals detecting unit (5) by frequency filtering of a signal from the same current sensor (3) from which high-frequency current signals are received, or from an additional current sensor of any type;
2) the process of analyzing PMC signals can be invoked only by HF-initiation;
3) a frequency band for analysis of PMC signals should be rather low (correspondingly, analysis time should be rather great) in order an amplitude of PMC signals does not depend on reactive components of the protected circuit and is defined only by the active component of impedance of an arcing region;
4) analysis time should be rather small in comparison with the network voltage half-cycle (correspondingly, a frequency band for analysis should be rather wide) in order an analysis of a PMC signal after possible low-current high-frequency pulses does not take too much time, since otherwise the reaction of the AFDD (1) to other events in a given half-cycle may be blocked.

The contradictoriness of the above requirement 4 to analysis time and requirement 3 to a frequency band for analyzing PMC signals has led to the necessity of performing additional experimental studies. As a result, an optimal frequency band for PMC signals is determined: it is in the range from app. 0.1 to app. 20 kHz, most preferably from 0.3 to 15 kHz, and a time interval for analyzing a response to single high-frequency disturbance is from 5 to 50-100 µs after disturbance.

The circuit for forming a PMC signal may be, for example, an oscillatory circuit in the mid-frequency current signal detecting unit (5). Alternatively, all necessary frequency filtering may be performed by the microcontroller (6). Other embodiments of the PMC are also possible.

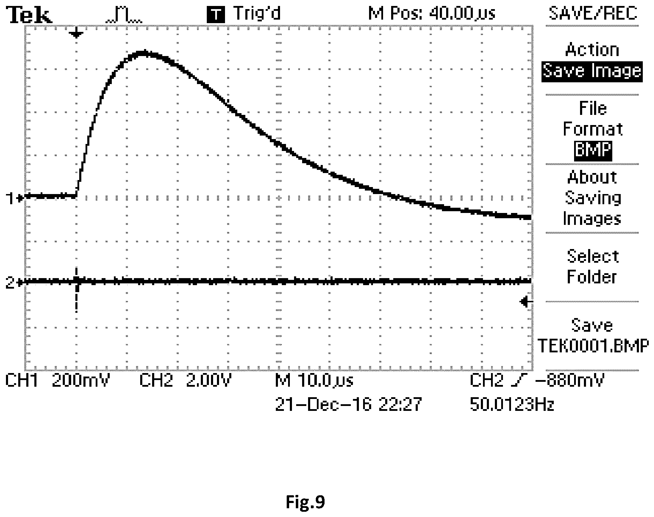

As an example, a case may be considered where the circuit for forming a PMC signal is the above oscillatory circuit with the resonance frequency of 10 kHz and a Q-factor somewhat less than 0.5. A PMC signal at the capacitor of such a circuit has a form shown in Figure 9; and the quality characteristic of a current rise, which is practically insensitive to values and arrangement of reactive members of the protected circuit, is an average value of this pulse in the interval from 5 to app. 70 µs from HF-initiation.

The division of a value of a current rise calculated upon receiving a PMC signal by the network voltage value existing at a time of high-frequency disturbance enables to determine a value of the active conductivity component of a region of possible arcing. Current consumption of a possible arcing region is determined by an obtained value; and the current consumption determined in this way is compared to a threshold value Ithr set with some reserve below the technical requirements to the AFDD (1) (for Standard IEC 62606:2013 this value is 2.5A at the network voltage of 230V). If a value Iarc of an arc current rise, which corresponds to arcing to resistance exceeds a threshold value Ithr, i.e. on the condition that Iarc< Ithr, an event is ignored; and the microcontroller (6) returns to the state of readiness for analyzing next events in a given half-cycle of the network (see Figure 7).

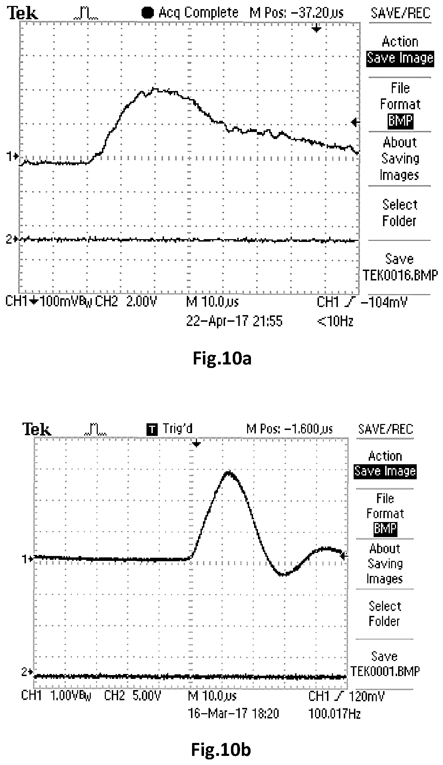

After HF-initiation and simultaneously with the above described analysis of PMC signals, MF-V signals from the mid-frequency voltage sensor are processed (see Figure 7). When a voltage pulse signal is formed, e.g. by doubly differentiating the network voltage at the AFDD (1) terminals with a time constant of app. 40 µs for both differentiating sections, a voltage pulse signal in a circuit of any configuration has clearly defined polarity within a time interval from 5 to 15 µs from the time of HF-initiation. As an example, Figures 10a and 10b show MF-V signal from the mid-frequency sensor at similar current rises in two different points of an extended and branched circuit. As can be seen, these signals have the same polarity clearly defined in the above time interval.

The purpose of processing a MF-V signal from the mid-frequency voltage sensor is to determine its polarity for confirming a location of an arcing source and a sign of disturbance within the protected circuit. This is necessary in order to avoid influence of processes occurring in circuits of other phases or the same phase outside a protected circuit. Intensity of inducing high-frequency signals from outside may be rather high in order to invoke HF-initiation, which is especially dangerous near a zero-crossing phase of the protected circuit, since a HF-initiation threshold is low at that time, and the coefficient for converting a PMC signal into conductivity of an arc region is high, while processes in circuits of adjacent phases may occur at maximum voltage values and, and for this reason, may have great intensity at that time.

This problem may be solved by comparing polarities of PMC signals, i.e. mid-frequency current signals MF-I and signals MF-V from the mid-frequency voltage sensor.

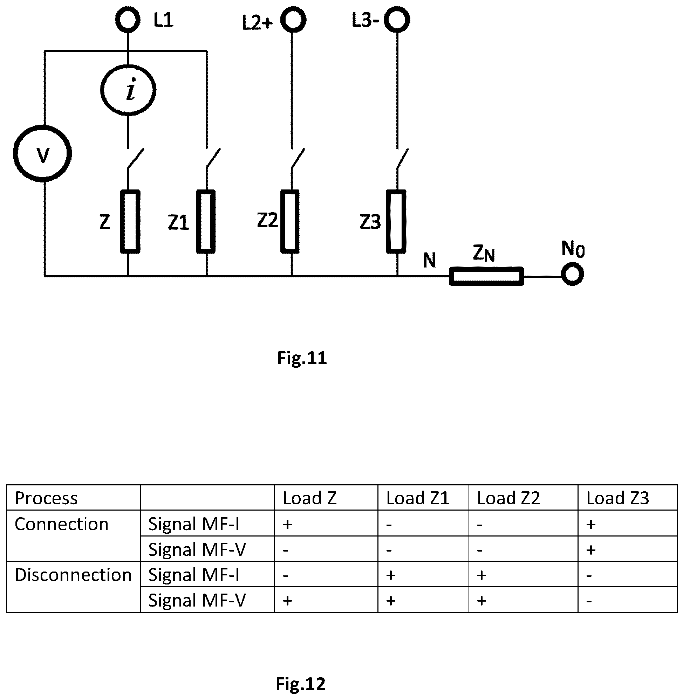

Let's consider a polarity diagram for mid-frequency current signals MF-I and signals MF-V from a mid-frequency voltage sensor at connecting and disconnecting loads in a protected circuit and adjacent circuits. A conditional scheme of disturbance detection may be presented in the form shown in Figure 11. Here, V and i are AFDD voltage and current sensors, respectively; Z is a switched load in a protected circuit; Z1 is a load in an adjacent circuit connected to the same phase L1 as the protected circuit; Z2 is a load in another phase L2 having the same polarity with phase L1 at a time of disturbance; Z3 is a load in the third phase L3 having the polarity opposite to that of phase L1 at the time of disturbance; Z_{N} is an impedance of neutral N. Mid-frequency components of switching processes, including arc faults, influence the voltage sensor V and the current sensor i conductively due to non-zero impedance Z_{N} of the circuit between a local connection point N of the load neutral wires and a point N₀ of initial neutral voltage generation. Switching of the loads Zl, Z2, Z3 creates a rise of potential at the point N relative to N₀ and, consequently, relative to phase potentials, thus generating voltage and current rises in the voltage sensor V and the current sensor i.

In accordance with the scheme shown in Figure 11, Figure 12 shows a polarity table for pulses of mid-frequency current signals MF-I (or PMC signals) and MF-V signals from the mid-frequency voltage sensor at connecting and disconnecting loads in the protected circuit and the adjacent circuits in the positive network half-cycle. The pulse signal polarity of the mid-frequency current signals is taken as positive when current in the protected circuit increases; and all the polarities will simply change the sign in the negative half-cycle.

As can be seen in Figure 12, a combination of polarities of the mid-frequency current signals and signals from the mid-frequency voltage sensor, which is not repeated during another switching, corresponds to a connection of the load Z occurring, in particular, at an arc fault in the protected circuit. Therefore, after HF-initiation simultaneously with an analysis of PMC response, the respective signal from the mid-frequency voltage sensor is directed for confirmation of its presence and polarity. In the simplest variant, this may be done by a separate comparator, or, alternatively, by the microcontroller (6). If such confirmation is absent within the next 5-15 µs, the PMC signal analysis is stopped, and the microcontroller (6) returns to the state of readiness for analyzing next events.

If all the above criteria are complied with, the presence of an isolated arc (IA) in the protected circuit in this half-cycle is reckoned to be confirmed (see Figure 7), and the AFDD (1) transfers to the second analysis step.

In the second step, the AFDD transfers from the identification of an IA to the identification of arcing itself. This step may be realized by various methods known, for example, from the above-mentioned patent documents. Below, one more variant of determining an arcing event with the use of a confirmed IA, which, along with the known ones, may be used for implementing this invention, is presented.

When the microcontroller (6) detects an isolated arc in a given half-cycle, a certain number of scores are added to a digital counter being, for example, a constituent part of the microcontroller (6). If a non-zero sum of scores is present in the digital counter, a pre-set sum of scores is deducted from it in each half-cycle. Values for additions and deductions are selected in such a way that at a sufficient recurrence rate of half-cycles with IAs, a total sum of scores reaches a pre-set limit at which the microcontroller (6) issues a command to disconnect the protected circuit to the disconnection member (8). Here, the sufficient recurrence rate of half-cycles with IAs is understood as rate in combination with a number of load arcing connections in the protected circuit, which are extremely unlikely in the conditions of real operation of a non-spark producing circuit. And a sum added to the digital counter may be made depending on an arcing current value calculated in this half-cycle, e.g. may be increased with its increment, for the purpose of shortening the device activation time at great arcing currents.

If an arcing event is confirmed, the microcontroller (6) issues a control signal for the disconnection member (8), and the disconnection member (8) disconnects the protected circuit of electrical installations (10) from the electrical network.

Thus, this invention enables much more accurate and definite fixation of an arcing event in a protected circuit, reducing a number of false activations significantly. Consequently, an area of monitoring possible arcing in a protected circuit is expanded, a number of electrical appliances connected to the protected circuit is increased, the length of the protected circuit and the number of branches it contains enlarges.

## Claims

1. A method of operating an arc protection device (AFDD), wherein voltage signals and current signals in a protected circuit are measured in each voltage half-cycle;
on the basis of the measured voltage signals and the measured current signals a presence of an isolated arc is determined in each voltage half-cycle;
information about the isolated arcs is gathered over a set time period, and said information is stored in the form of a parameter for detecting an arcing;
upon reaching a preset value by said parameter for detecting an arcing, an arcing is detected; and
a signal to disconnect the protected circuit from a network is generated;
wherein measuring the voltage signals and the current signals includes measuring a current in a high-frequency band ranging from 1 to 10 MHz, and, on a condition that the current measured in the high-frequency band is higher than a preset value, measuring:
the current in a mid-frequency band ranging from 0.1 to 20 kHz,
a voltage in a low-frequency band smaller than the frequencies of the mid-frequency band, and
the voltage in said mid-frequency band,
wherein the current in the high-frequency band is measured at a rise region of a network voltage, and
wherein determining the presence of an isolated arc is confirmed if:
an arc current determined based on the values of the current in the mid-frequency band and the voltage in the low-frequency band exceeds a threshold value, and
polarities of the current in the mid-frequency band and the voltage in the mid-frequency band conform to a preset combination.

2. The method of operating the AFDD according to Claim 1, wherein the current in a mid-frequency band ranges from 0.3 to 15 kHz.

3. The method of operating the AFDD according to Claim 1, wherein an arc current is determined by measuring voltage in the low-frequency band, preferably with measurement rate from 10 to 40 kHz, more preferably with measurement rate from 20 to 30 kHz.

4. The method of operating the AFDD according to Claim 3, wherein, essentially simultaneously with determination of the arc current, polarities of voltage signals in the mid-frequency band are determined by measuring voltage in the mid-frequency band, preferably in a sub-band from 1 to 50 kHz, more preferably in a sub-band from 5 to 50 kHz.

5. An arc protection device comprising:
a power unit (7), at least one voltage reading unit (2), at least one current sensor (3), a high-frequency current signal detecting unit (4), a mid-frequency current signal detecting unit (5),
the at least one voltage reading unit (2) comprising at least one low-frequency voltage sensor and at least one mid-frequency voltage sensor, the arc protection device further comprising
a microcontroller (6) configured to interact with said high-frequency current signal detecting unit (4), mid-frequency current signal detecting unit (5), at least one low-frequency voltage sensor and at least one mid-frequency voltage sensor, to gather information about isolated arcs and generating a signal for disconnection of a protected circuit by implementing the method as defined in any of claims 1 to 4.

## Patentansprüche

1. Verfahren zum Betreiben einer Lichtbogenschutzvorrichtung (AFDD), bei dem in jedem Spannungshalbzyklus Spannungssignale und Stromsignale in einem geschützten Stromkreis gemessen werden;
auf der Grundlage der gemessenen Spannungssignale und der gemessenen Stromsignale in jedem Spannungshalbzyklus festgestellt wird, ob ein isolierter Lichtbogen vorliegt;
Informationen über die isolierten Lichtbögen über einen vorgegebenen Zeitraum gesammelt und die Informationen in Form eines Parameters zum Detektieren einer Lichtbogenbildung gespeichert werden;
eine Lichtbogenbildung detektiert wird, wenn der genannte Parameter zum Detektieren einer Lichtbogenbildung einen vorgegebenen Wert erreicht; und
ein Signal zum Trennen des geschützten Stromkreises von einem Netz erzeugt wird; wobei das Messen der Spannungssignale und der Stromsignale ein Messen eines Stroms in einem Hochfrequenzband im Bereich von 1 bis 10 MHz umfasst, sowie, unter der Bedingung, dass der im Hochfrequenzband gemessene Strom höher als ein vorgegebener Wert ist, ein Messen von:
dem Strom in einem Mittelfrequenzband im Bereich von 0,1 bis 20 kHz,
einer Spannung in einem Niederfrequenzband, das kleiner ist als die Frequenzen des Mittelfrequenzbandes, und
der Spannung in dem Mittelfrequenzband,
wobei der Strom im Hochfrequenzband in einem Anstiegsbereich einer Netzspannung gemessen wird, und
wobei das Vorliegen eines isolierten Lichtbogens bestätigt wird, wenn:
ein Lichtbogenstrom, der basierend auf den Werten des Stroms im Mittelfrequenzband und der Spannung im Niederfrequenzband ermittelt wird, einen Schwellenwert überschreitet und
Polaritäten des Stroms im Mittelfrequenzband und der Spannung im Mittelfrequenzband einer vorgegebenen Kombination entsprechen.

2. Verfahren zum Betreiben der AFDD nach Anspruch 1, wobei der Strom in einem Mittelfrequenzband im Bereich von 0,3 bis 15 kHz liegt.

3. Verfahren zum Betreiben der AFDD nach Anspruch 1, wobei ein Lichtbogenstrom durch Messen einer Spannung im Niederfrequenzband ermittelt wird, vorzugsweise mit einer Messrate von 10 bis 40 kHz, stärker bevorzugt mit einer Messrate von 20 bis 30 kHz.

4. Verfahren zum Betreiben der AFDD nach Anspruch 3, wobei, im Wesentlichen simultan mit der Bestimmung des Lichtbogenstroms, Polaritäten von Spannungssignalen im Mittelfrequenzband durch Messen der Spannung im Mittelfrequenzband bestimmt werden, vorzugsweise in einem Unterband von 1 bis 50 kHz, stärker bevorzugt in einem Unterband von 5 bis 50 kHz.

5. Lichtbogenschutzvorrichtung, die das Folgende aufweist:
eine Leistungseinheit (7), mindestens eine Spannungserfassungseinheit (2), mindestens einen Stromsensor (3), eine Detektionseinheit (4) für Hochfrequenz-Stromsignale, eine Detektionseinheit (5) für Mittelfrequenz-Stromsignale,
wobei die mindestens eine Spannungserfassungseinheit (2) mindestens einen Niederfrequenz-Spannungssensor und mindestens einen Mittelfrequenz-Spannungssensor aufweist, wobei die Lichtbogenschutzvorrichtung ferner das Folgende aufweist:
einen Mikrocontroller (6), der dazu konfiguriert ist, mit der Detektionseinheit (4) für Hochfrequenz-Stromsignale, der Detektionseinheit (5) für Mittelfrequenz-Stromsignale, mindestens einem Niederfrequenz-Spannungssensor und mindestens einem Mittelfrequenz-Spannungssensor zusammenzuwirken, um Informationen über isolierte Lichtbögen zu sammeln und ein Signal zur Trennung eines geschützten Stromkreises zu erzeugen, indem das Verfahren nach einem der Ansprüche 1 bis 4 durchgeführt wird.

## Revendications

1. Procédé de fonctionnement d'un dispositif de protection contre les arcs (AFDD), dans lequel des signaux de tension et des signaux de courant dans un circuit protégé sont mesurés dans chaque demi-cycle de tension ;
sur la base des signaux de tension mesurés et des signaux de courant mesurés, la présence d'un arc isolé est déterminée dans chaque demi-cycle de tension ;
des informations concernant les arcs isolés sont recueillies dans une période de temps définie, et lesdites informations sont stockées sous la forme d'un paramètre de détection d'une formation d'arc ;
en atteignant une valeur prédéfinie par ledit paramètre de détection d'une formation d'arc, une formation d'arc est détectée ; et
un signal pour déconnecter le circuit protégé d'un réseau est généré ;
dans lequel la mesure des signaux de tension et des signaux de courant comporte la mesure d'un courant dans une bande haute fréquence se situant entre 1 et 10 MHz, et à condition que le courant mesuré dans la bande haute fréquence soit supérieur à une valeur prédéfinie, la mesure :
du courant dans une bande moyenne fréquence se situant entre 0,1 et 20 kHz,
d'une tension dans une bande basse fréquence inférieure aux fréquences de la bande moyenne fréquence, et
de la tension dans ladite bande moyenne fréquence,
dans lequel le courant dans la bande haute fréquence est mesuré dans une région de montée d'une tension de réseau, et
dans lequel la détermination de la présence d'un arc isolé est confirmée si :
un courant d'arc déterminé sur la base des valeurs du courant dans la bande moyenne fréquence et de la tension dans la bande basse fréquence dépasse une valeur seuil, et
les polarités du courant dans la bande moyenne fréquence et la tension dans la bande moyenne fréquence sont conformes à une combinaison prédéfinie.

2. Procédé de fonctionnement de l'AFDD selon la revendication 1, dans lequel le courant dans une bande moyenne fréquence se situe entre de 0,3 à 15 kHz.

3. Procédé de fonctionnement de l'AFDD selon la revendication 1, dans lequel un courant d'arc est déterminé en mesurant la tension dans la bande basse fréquence, de préférence avec des taux de mesure se situant entre 10 et 40 kHz, de manière davantage préférée avec des taux de mesure se situant entre 20 et 30 kHz.

4. Procédé de fonctionnement de l'AFDD selon la revendication 3, dans lequel, pratiquement simultanément à la détermination du courant d'arc, les polarités des signaux de tension dans la bande moyenne fréquence sont déterminées en mesurant la tension dans la bande moyenne fréquence, de préférence dans une sous-bande se situant entre 1 et 50 kHz, de manière davantage préférée dans une sous-bande se situant entre 5 et 50 kHz.

5. Dispositif de protection contre les arcs comprenant :
une unité d'alimentation (7), au moins une unité de lecture de tension (2), au moins un capteur de courant (3), une unité de détection de signal de courant haute fréquence (4), une unité de détection de signal de courant moyenne fréquence (5),
l'au moins une unité de lecture de tension (2) comprenant au moins un capteur de tension basse fréquence et au moins un capteur de tension moyenne fréquence, le dispositif de protection contre les arcs comprenant en outre
un microcontrôleur (6) configuré pour interagir avec ladite unité de détection de signal de courant haute fréquence (4), ladite unité de détection de signal de courant moyenne fréquence (5), ledit au moins un capteur de tension basse fréquence et ledit au moins un capteur de tension moyenne fréquence afin de recueillir des informations concernant des arcs isolés et de générer un signal pour déconnecter un circuit protégé en mettant en œuvre le procédé tel que défini dans l'une des revendications 1 à 4.
